# EUROPEAN PATENT APPLICATION

(11) **EP 4 672 246 A2**
(43) Date of publication of application: **31.12.2025**
(21) Application number: 25184581.4
(22) Date of filing: 23.06.2025
(51) Int. Cl.: G11C 29/38, G11C 29/44

(54) **FAST, LOW AREA SELF-TEST FOR READ-ONLY MEMORY**

(30) Priority: 26.06.2024 US 202463664235 P; 02.06.2025 US 202519225376
(71) Applicant: STMicroelectronics International N.V., 1228 Plan-les-Ouates, Geneva (CH)
(72) Inventor: SINGH, Rupesh, 201012 UP (IN); BAL, Ankur, 201308 UP (IN); HOIZAL, Tejas Kumar, 201306 NOIDA (IN)
(74) Representative: Casalonga

(57) **Abstract**

Methods for performing a fast read-only memory (ROM) test are disclosed. In the first method, a signature is generated by performing a first set of N read operations utilizing an extended read-cycle, followed by a second set of N read operations utilizing an at-speed read-cycle, where N is an integer greater than or equal to 2. The retrieved data is combined using modulo addition and subtraction operations and stored in a signature register. In the second, a signature is generated by performing two read operations utilizing an extended read-cycle, followed by two read operations utilizing an at-speed read-cycle. The retrieved data is combined using exclusive OR (XOR) operations and stored in a signature register. The final signature is compared to a predetermined value to determine if any errors were detected. Both methods provide a robust test capable of detecting various ROM errors while minimizing test time and complexity.

## Description

### TECHNICAL FIELD

This disclosure is directed to the field of read-only memories, and, in particular, to a read-only memory including a fast self-test circuit that consumes a low amount of area.

### BACKGROUND

In recent years, the complexity of System-on-Chip (SoC) designs has grown exponentially, leading to a significant increase in the use of embedded memory. As a result, ensuring the reliability and thorough testing of these memories has become a critical aspect of the design process. Memory Built-In-Self-test (MBIST) has emerged as a widely adopted technique for testing embedded memories, offering a comprehensive solution for detecting and identifying memory faults.

BIST is a self-contained testing mechanism that integrates test algorithms, pattern generators, and response analyzers directly into the SoC. This approach enables the efficient testing of embedded memories without the need for external test equipment. By generating test patterns and comparing the memory outputs with expected results, a BIST can detect various types of memory faults, including stuck-at faults, coupling faults, and address decoder faults.

However, achieving complete coverage of embedded memories using BIST can be time-consuming in terms of execution. Indeed, as the size and number of embedded memories in SoCs grows, the test time required for comprehensive BIST testing increases significantly. This poses a challenge in different stages of the design manufacturing process and infield testing.

During the Electrical Wafer Sort (EWS) phase, where initial testing of fabricated wafers takes place, it is desired to have complete and extensive test coverage of the embedded memories. However, minimizing the BIST run time is desirable while still maintaining the required test coverage.

To address the challenge of reducing test time in random access memory (RAM) while maintaining the required coverage, fast BIST algorithms have been developed. These algorithms aim to optimize the test process by generating a limited set of data patterns that effectively target potential faults in the RAM structure. By focusing on a limited number of critical patterns, the fast BIST algorithm can significantly reduce the time required for gate-level simulations and in-field quick testing.

Testing Read-Only Memory (ROM), however, presents a specific set of challenges. In the case of ROM, the BIST process is heavily dependent on the data and signature stored within the memory.

Since the content of the ROM cannot be modified during normal operation, it is impossible to apply the same fast MBIST techniques used for RAM.

To test a ROM using BIST, the conventional approach involves reading the complete ROM data and comparing the generated signature with the stored signature. This process requires accessing every memory location and computing a signature based on the retrieved data. The generated signature is then compared with a pre-calculated signature stored in the ROM to verify the integrity of the memory content.

This process, however, requires an undesirable amount of time, depending on the size of the SoC and ROM. As such, further development is needed.

### SUMMARY

Disclosed herein are two methods for performing a fast read-only memory (ROM) test without requiring knowledge of the complete ROM data. These methods aim to minimize test time and complexity while providing a robust test capable of detecting various ROM errors.

The first method offers a more flexible approach by allowing a variable number of read operations. In this method, a signature is generated by performing a first set of N read operations utilizing an extended read cycle, followed by a second set of N read operations utilizing a standard at-speed read cycle, where N is an integer greater than or equal to 2. While N is to be at least 2, this approach is more flexible than the first method as N can be increased to test larger portions of the ROM The retrieved data is combined using modulo addition operations for the first set of N read operations and modulo subtraction operations for the second set of N read operations. The results are stored in a signature register, and the final signature is compared to a predetermined value to determine if any errors were detected.

The second method generates a signature by performing two read operations utilizing an extended read cycle, followed by two read operations utilizing a standard at-speed read cycle. During the extended read cycle, the read bit lines are given more time to settle, allowing the true ROM data to be retrieved. The at-speed read cycle retrieves the data as it would be read during normal operation. The retrieved data from each pair of read operations is combined using exclusive OR (XOR) operations and stored in a signature register. The final signature is then compared to a predetermined value, which is a word comprised of all logic 0's if no errors have been detected.

In conclusion, both methods effectively compare the data retrieved under ideal conditions (extended read cycles) with the data retrieved under normal operating conditions (at-speed read cycles) to detect discrepancies that would indicate ROM errors.

### BRIEF DESCRIPTION OF THE DRAWINGS

FIG. 1 is a block diagram of a read-only memory (ROM) device disclosed herein.
FIG. 2A is a block diagram of a first embodiment of the signature generator circuitry of the ROM device of FIG. 1.
FIG. 2B is a block diagram of a second embodiment of the signature generator circuitry of the ROM device of FIG. 1.

### DETAILED DESCRIPTION

The following disclosure enables a person skilled in the art to make and use the subject matter described herein. The general principles outlined in this disclosure can be applied to embodiments and applications other than those detailed above without departing from the spirit and scope of this disclosure. It is not intended to limit this disclosure to the embodiments shown, but to accord it the widest scope consistent with the principles and features disclosed or suggested herein.

This disclosure addresses the desire for a quick self-test run option for ROM by generating the signature of partial, scattered ROM content without requiring knowledge of the complete ROM data. This process involves traversing a limited number of addresses and performing a sequence of operations that result in a fixed, implicit computed signature.

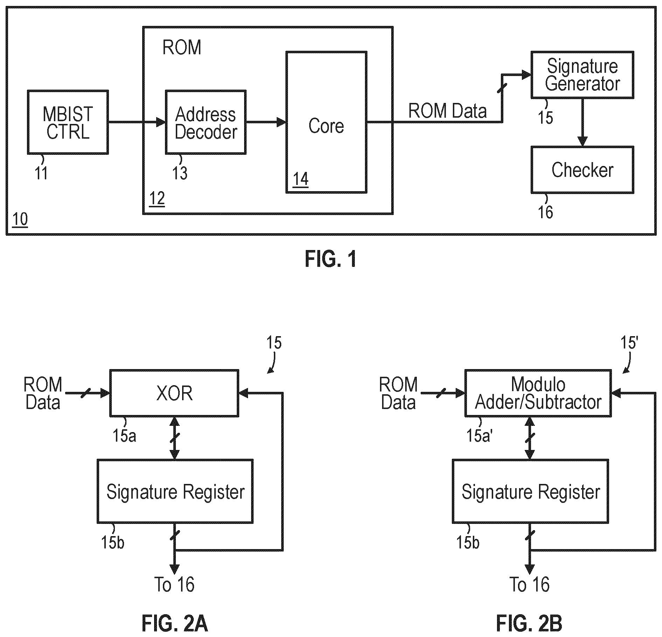

Refer now to the ROM device 10 shown in FIG. 1. In operation, the memory built in self-test (MBIST) controller 11 initiates the fast ROM test sequence. The address decoder 13 generates the addresses to access specific locations in the ROM core 14. The ROM data is then read from those locations and fed into the signature generator 15, which performs operations based on the accessed data to yield a final signature. When the fast ROM test has been passed to indicate a lack of errors, the final signature is a logic zero. The checker module 16 compares the final signature to the expected value, which as stated is zero.

A first embodiment of the signature generator 15 is now described with reference to FIG. 2A. At the initiation of the fast ROM test sequence, the signature register 15b is reset. Thereafter, a specific address (typically a desired final address of the ROM core 14) - this address may correspond to the last word stored in the ROM core 14, or may correspond to the last word stored in a desired address range. This first read is performed utilizing an extended read cycle, with the read being performed over multiple clock cycles to give the read bit lines more time to settle than they would have during a standard at-speed read performed during a single clock cycle. The ROM data retrieved during this first read is then logically exclusive OR'd (XOR'd) by an XOR circuit 15a with the current contents of the signature register 15b, which is a word comprised of logic zeros at this point, and the result is stored in the signature register 15b to overwrite the previous contents thereof. Therefore, the ROM data retrieved during the first read is stored in the signature register 15b at this point, due to XOR logic.

Next, a second read is performed utilizing the extended read cycle. For this second read, the address read is the complement of the first address read (e.g., the address read during the second cycle may be the complement of the final address or the complement of the address of the last word stored in the desired address range). As an example, if the final address (so, the address read during the first read) was a binary '1111', then the address of the second read is a binary '0000'. The ROM data retrieved during this second read is then logically XOR'd by the XOR circuit 15a with the current contents of the signature register 15b, which is the first ROM data (the data retrieved during the first read) at this point. The results of this second logic XOR operation are then stored in the signature register 15b to overwrite the previous contents thereof.

The above two read/XOR operations are then performed again at-speed. The address accessed during the third read is again the desired final address of the ROM core 14, or the address of the last word stored in the desired address range. The ROM data retrieved during this third read is logically XOR'd by the XOR circuit 15a with the current contents of the signature register 15b. The result of this third XOR operation is stored in the signature register 15b, overwriting the previous contents.

The fourth and final read is then performed at-speed, with the address being accessed being the complement of the address accessed during the third read. The ROM data retrieved during this fourth read is XOR'd with the current contents of the signature register 15b by the XOR circuit 15a. The result is stored in the signature register 15b as the final signature value.

If no errors have been detected during the at-speed ROM test sequence, the final signature value stored in the signature register 15b will be a word comprised of all logic 0's. This is because the XOR operations will cancel out the ROM data, since the data from the first and third reads (which access the same address) will be identical, as will the data from the second and fourth reads (which access the same address). Therefore, XORing identical data patterns will always yield logic 0's.

In summary, the signature is generated by performing four reads total - two utilizing an extended read cycle and two utilizing a standard at-speed read cycle. The data from each read is XOR'd with the current signature register contents, with the signature register being reset at the start of the fast ROM test sequence. The addresses accessed are the desired final address and its complement, with these two addresses being accessed first during the extended read cycles and then again during the at-speed read cycles. If no errors are present, the final signature will be all logic 0's due to the XOR operations cancelling out the error-free ROM data.

An alternate embodiment of the signature generator 15' is now described with reference to FIG. 2B. At the initiation of the fast ROM test sequence, the signature register 15b is reset. Thereafter, a desired final address of the ROM core 14 (or the address of the last word stored in the desired address range) is read utilizing an extended read cycle, as described previously. The ROM data retrieved during this first read is then modulo added by a modulo adder/subtractor 15a' with the current contents of the signature register 15b, which is a word comprised of logic zeros at this point. The result of this modulo addition operation is stored in the signature register 15b to overwrite the previous contents thereof.

Next, a second read is performed utilizing the extended read cycle, with the address read being the complement of the first address read. The ROM data retrieved during this second read is then modulo added by the modulo adder/subtractor 15a' with the current contents of the signature register 15b. The results of this second modulo addition operation are then stored in the signature register 15b to overwrite the previous contents thereof.

The above two read/modulo add operations are then performed again, but this time utilizing standard at-speed read cycles. The address accessed during the third read is again the desired final address of the ROM core 14, or the address of the last word stored in the desired address range. The ROM data retrieved during this third read is modulo subtracted by the modulo adder/subtractor 15a' from the current contents of the signature register 15b. The result of this third modulo operation is stored in the signature register 15b, overwriting the previous contents.

The fourth and final read is then performed at-speed, with the address being accessed being the complement of the address accessed during the third read. The ROM data retrieved during this fourth read is modulo subtracted by the modulo adder/subtractor 15a' from the current contents of the signature register 15b. The result is stored in the signature register 15b as the final signature value.

If no errors have been detected during the fast ROM test sequence, the final signature value stored in the signature register 15b will be a word comprised of all logic 0's. This is because the modulo addition and subtraction operations will cancel out the ROM data, since the data from the first and third reads (which access the same address) will be identical, as will the data from the second and fourth reads (which access the same address).

The second embodiment of the signature generator 15', which utilizes the modulo addition and subtraction operations, provides flexibility in the number of read cycles performed. While the previously described implementation of this second embodiment utilized two extended read/modulo addition cycles followed by two at-speed read/modulo subtraction cycles, this embodiment can be generalized to use any number N of extended read/modulo addition cycles followed by N at-speed read/modulo subtraction cycles. By increasing the number of read cycles performed, any desired portion of the ROM core 14 can be read and tested by the fast ROM test sequence. For example, if it is desired to test a larger portion of the ROM core 14, the number of read cycles N can be increased, with each additional pair of extended and at-speed read cycles reading and comparing the data from additional addresses within the ROM. The addresses accessed during these additional read cycles may be chosen to cover a larger contiguous portion of the ROM core 14, or may be scattered throughout the ROM to test various non-contiguous portions. Regardless of the number of read cycles performed or the specific addresses accessed, the signature generator 15' will combine the data retrieved during the extended read cycles with the data retrieved during the corresponding at-speed read cycles using modulo addition and subtraction operations, respectively. If no errors are present, the final signature will be a word comprised of all logic 0's, as previously described. Therefore, the second embodiment of the signature generator 15' provides a flexible and scalable approach to testing any desired portion of the ROM core 14 using the fast ROM test sequence.

In the first embodiment of the signature generator 15, which utilizes XOR operations, the use of an extended read cycle for the first two reads ensures that the correct ROM data is retrieved, even if there is an issue with the ROM core 14 that would prevent the data from being properly read during a standard at-speed read cycle. By extending the read cycle over multiple clock cycles, the read bit lines are given more time to settle than they would have during a standard at-speed read performed during a single clock cycle. This allows the true ROM data to be retrieved and operated on by the signature generator 15, providing a baseline for what the data should be. Conversely, the use of standard at-speed read cycles for the second two reads is designed to retrieve the ROM data as it would be read during normal, at-speed operation of the ROM core 14. By performing these final two reads at-speed, any errors that would prevent the correct data from being read during normal operation of the ROM will be captured. The signature generator 15 effectively compares the data retrieved during the extended read cycles (the "true" data) with the data retrieved during the at-speed read cycles (the data as it would be read during normal operation) by combining them via the XOR operations. If there are no discrepancies between the data retrieved during the extended and at-speed read cycles, the final signature will be a word comprised of all logic 0's, indicating that no errors were detected.

The second embodiment of the signature generator 15', which utilizes modulo addition and subtraction operations, provides a more flexible and generalized approach. In this embodiment, any number N of extended read/modulo addition cycles can be followed by N at-speed read/modulo subtraction cycles. This allows for testing of any desired portion of the ROM core 14, as previously described. Similar to the XOR embodiment, the extended read cycles in the modulo embodiment retrieve the true ROM data, while the at-speed read cycles retrieve the data as it would be read during normal operation. The signature generator 15' compares these two sets of data by combining them via the modulo addition and subtraction operations. If no errors are present, the final signature will be a word comprised of all logic 0's.

Therefore, both embodiments of the signature generator (15 and 15') provide a robust test that can detect a variety of potential ROM errors by comparing the data retrieved under ideal conditions (extended read cycles) with the data retrieved under normal operating conditions (at-speed read cycles), using either XOR or modulo operations to combine the retrieved data and check for discrepancies. By focusing on a limited number of read operations and utilizing simple data combination techniques (XOR or modulo addition/subtraction), both embodiments provide efficient and effective ROM testing while reducing test time and complexity compared to traditional approaches that require reading the entire ROM contents.

Finally, it is evident that modifications and variations can be made to what has been described and illustrated herein without departing from the scope of this disclosure.

Although this disclosure has been described with a limited number of embodiments, those skilled in the art, having the benefit of this disclosure, can envision other embodiments that do not deviate from the disclosed scope. Furthermore, skilled persons can envision embodiments that represent various combinations of the embodiments disclosed herein made in various ways.

## Claims

1. A method for performing a fast read-only memory (ROM) signature test, comprising:
resetting a signature register;
performing a first set of N read operations of ROM data from N addresses of a ROM core utilizing an extended read cycle over multiple clock cycles, where N is an integer greater than or equal to 2;
for each read operation in the first set of N read operations:
performing a modulo addition operation of the ROM data retrieved during the read operation with contents of the signature register using a modulo adder, and
storing a result of the modulo addition operation in the signature register;
performing a second set of N read operations of ROM data from the N addresses of the ROM core utilizing an at-speed read cycle, the at-speed read cycle being performed over a single clock cycle;
for each read operation in the second set of N read operations:
performing a modulo subtraction operation of the ROM data retrieved during the read operation from the contents of the signature register using the modulo adder, and
storing a result of the modulo subtraction operation in the signature register; and
comparing a final signature value stored in the signature register after the second set of N read operations to a predetermined value to determine if any errors were detected during the fast ROM test, wherein the predetermined value is a word comprised of all logic 0's if no errors have been detected.

2. The method of claim 1, wherein the N addresses are chosen to cover a contiguous portion of the ROM core or wherein the N addresses are scattered throughout the ROM core to test various non-contiguous portions.

3. The method of claim 1, wherein the first set of N read operations retrieves true ROM data and the second set of N read operations retrieves ROM data as it would be read during normal operation of the ROM core.

4. A method for performing a fast read-only memory (ROM) signature test, comprising:
resetting a signature register;
performing a first read of ROM data from a desired final address of a ROM core utilizing an extended read cycle over multiple clock cycles;
performing a first exclusive OR (XOR) operation of the ROM data retrieved during the first read with contents of the signature register using an XOR circuit;
storing a result of the first XOR operation in the signature register;
performing a second read of ROM data utilizing the extended read cycle, wherein an address read during the second read is a complement of the desired final address;
performing a second XOR operation of the ROM data retrieved during the second read with the contents of the signature register using the XOR circuit;
storing a result of the second XOR operation in the signature register;
performing a third read of the ROM data from the desired final address of the ROM core utilizing an at-speed read cycle, the at-speed read cycle being performed during one clock cycle;
performing a third XOR operation of the ROM data retrieved during the third read with the contents of the signature register using the XOR circuit;
storing a result of the third XOR operation in the signature register;
performing a fourth read of the ROM data utilizing the at-speed read cycle, wherein an address read during the fourth read is the complement of the desired final address;
performing a fourth XOR operation of the ROM data retrieved during the fourth read with the contents of the signature register using the XOR circuit; and
storing a result of the fourth XOR operation in the signature register as a final signature value, wherein the final signature value is a word comprised of all logic 0's if no errors have been detected during the fast ROM test.

5. The method of claim 4, wherein the desired final address corresponds to a last word stored in the ROM core or wherein the desired final address corresponds to a last word stored in a desired address range of the ROM core.

6. The method of claim 4, wherein the first read and the second read utilizing the extended read cycle retrieve true ROM data, and the third read and the fourth read utilizing the at-speed read cycle retrieve ROM data as it would be read during normal operation of the ROM core.

7. The method of claim 1 or claim 4, wherein the fast ROM test is initiated by a memory built-in self-test (MBIST) controller.

8. A method for testing a read-only memory (ROM) device, comprising:
performing a first read operation using an extended read cycle to access a first address in a ROM core, the extended read cycle being performed over multiple clock cycles;
performing a second read operation using the extended read cycle to access a second address in the ROM core, wherein the second address is a complement of the first address;
performing a third read operation using an at-speed read cycle to access the first address in the ROM core, the at-speed read cycle being performed over a single clock cycle;
performing a fourth read operation using the at-speed read cycle to access the second address in the ROM core;
combining data retrieved from each read operation to generate a final signature; and
comparing the final signature to an expected value to determine if errors are present in the ROM core.

9. The method of claim 8, wherein combining the data retrieved from each read operation comprises:
resetting a signature register at initiation of a test sequence;
performing a first logic operation to combine data retrieved from the first read operation with contents of the signature register;
performing a second logic operation to combine data retrieved from the second read operation with updated contents of the signature register;
performing a third logic operation to combine data retrieved from the third read operation with updated contents of the signature register; and
performing a fourth logic operation to combine data retrieved from the fourth read operation with updated contents of the signature register.

10. The method of claim 9, wherein the first, second, third, and fourth logic operations are exclusive OR (XOR) operations.

11. The method of claim 10, wherein the final signature is a word comprised of all logic 0's when no errors are detected in the ROM core.

12. The method of claim 9, wherein:
the first and second logic operations are modulo addition operations; and
the third and fourth logic operations are modulo subtraction operations.

13. The method of claim 12, further comprising:
performing N extended read operations using extended read cycles;
performing N at-speed read operations using standard at-speed read cycles;
modulo adding data retrieved from each of the N extended read operations with contents of the signature register; and
modulo subtracting data retrieved from each of the N at-speed read operations from updated contents of the signature register.

14. The method of claim 8, wherein the extended read cycle is performed over multiple clock cycles to allow read bit lines more time to settle compared to the at-speed read cycle.

15. The method of claim 8, wherein the first address corresponds to a final address of the ROM core or a last word stored in a desired address range of the ROM core.

16. The method of claim 8, further comprising initiating a fast ROM test sequence using a memory built-in self-test (MBIST) controller.

17. The method of claim 8, wherein the expected value is a word comprised of all logic 0's.
